# EUROPEAN PATENT APPLICATION

(11) **EP 2 365 628 A1**
(43) Date of publication of application: **14.09.2011**
(21) Application number: 10290118.8
(22) Date of filing: 09.03.2010
(51) Int. Cl.: H03F 1/02

(54) **Signal preprocessing for envelope modulators**

(71) Applicant: Alcatel Lucent, 75008 Paris (FR)
(72) Inventor: Luz, Gerhard, 74321 Bietigheim-Bissingen (DE); Wiegner, Dirk, 71409 Schwaikheim (DE); Bohn, Thomas, 70372 Stuttgart (DE)
(74) Representative: Kohler Schmid Möbus

(57) **Abstract**

The invention relates to a method for conditioning of an envelope signal (10) to be provided as an input signal to an envelope tracking, ET, modulator, comprising: advancing the envelope signal (10) in the time domain at rising edges thereof for reducing a negative deviation between an output signal (12) of the ET modulator and the envelope signal (10). The invention also relates to a computer program product, to a frontend for a base station, to a base station, and to a communications network adapted for performing the method.

## Description

### Field of the Invention

The invention relates to the field of telecommunications, and, more specifically, to improvements for envelope (tracking) modulators which may be used e.g. for providing a modulated supply voltage to amplifiers, being used e.g. for amplification of RF signals to be transmitted by a base station.

### Background

This section introduces aspects that may be helpful in facilitating a better understanding of the invention. Accordingly, the statements of this section are to be read in this light and are not to be understood as admissions about what is in the prior art or what is not in the prior art.

In base stations of telecommunications networks, there is a need for amplification of RF signals before they are transmitted via RF antennas. For this purpose, power amplifiers are used which typically consume a considerable part of the power of a base station. Thus, it is desired to improve efficiency of power amplifiers (single- as well as multiband, single- as well as multi-standard) and thus efficiency of the total base station. In order to improve power amplifier efficiency, the Envelope Tracking (ET) concept has been proven to be a very promising approach. One main enabling component of Envelope Tracking concept is the ET modulator.

The ET modulator has to provide a sufficient bandwidth for the respectively addressed power class of the power amplifier, in order to achieve high efficiency and to support single- as well as multi-carrier or broadband signal applications. Using commercially available and qualified components for modulator design and realization, the ET modulator shows bandwidth limitations, resulting out of the component limitations. For instance, due to finite rising times of the switch-mode transistors used therein or limited large-signal bandwidth of the linear stage, the total modulator bandwidth is limited. Due to these bandwidth limitations, the modulator's bandwidth may not be sufficient for providing a sufficiently linear output signal, especially for e.g. four carrier Wideband Code Division Multiple Access, WCDMA, signals. The limited modulator bandwidth may be reflected in degraded overall system linearity which may not,be sufficiently corrected for even by using linearization methods such as e.g. digital pre-distortion.

In summary, the limited ET modulator bandwidth, which is due to limitations of the components used for implementing the ET modulator, results in a clear performance degradation of the overall Envelope Tracking system, especially for multi-carrier signals which have large signal bandwidths and thus typically require high modulator bandwidths.

### Summary

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention its sole purpose is to present some concepts in a simplified form as a prelude to the more detailed description that is discussed later.

One aspect of the invention relates to a method for conditioning of an envelope signal to be provided as an input signal to an envelope tracking, ET, modulator, comprising: advancing the envelope signal in the time domain at rising edges thereof for reducing a negative deviation between an output signal of the ET modulator and the envelope signal.

The basic idea of the inventors' solution is to reduce the required modulator bandwidth by suitable signal pre-conditioning of the envelope signal provided as an input to the ET modulator. Since the envelope signal is typically provided to the ET modulator by a digital ET platform, the exact envelope signal is thus known in the digital ET platform before providing it to the ET modulator.

The inventors have found that a negative deviation between the envelope signal at the input of the ET modulator and the output signal produced by the modulator (typically a voltage signal provided as a supply voltage to a power amplifier) is particularly detrimental for the present purposes. In particular, when such a signal is fed as a supply voltage to the power amplifier, it may lead to generation of higher harmonics in the power amplifier. However, generation of uneven harmonics will cause so-called adjacent channel power, ACP, in the amplified signal, which will lead to errors in adjacent channels and is thus strongly limited in the specification of standards such as UMTS or LTE.

In one variant, the envelope signal is not advanced at falling edges thereof. The inventors have found that advancing the signal at falling edges thereof will typically cause a negative deviation between the output signal and the input signal, which should be avoided for the reasons set out above.

In another variant, the method comprises: shifting the envelope signal in the time domain by a delay time for reducing an absolute value of a deviation between the output signal of the ET modulator and the envelope signal. The shifting of the output signal may be used to compensate for the group delay caused by the ET modulator. It should be noted, however, that shifting the envelope signal will affect both raising and falling edges thereof and will thus generate positive and negative deviations, albeit with reduced amplitudes.

In a further variant, the advancing and/or the shifting of the envelope signal is performed in the digital domain. As indicated above, the pre-processing of the envelope signal may be performed in a digital frontend of the base station, which has exact knowledge of the envelope signal to be provided to the ET modulator, as it also generates the signal from which the envelope signal is derived.

In one improvement, the method further comprises: performing a digital-to-analog conversion of the advanced and/or shifted envelope signal before providing the envelope signal to the ET modulator. When the pre-processing is performed in the digital domain, the envelope signal typically has to be converted to the analog domain before being fed to the ET modulator.

As discussed above, the output signal of the ET modulator is typically provided as a supply voltage to a power amplifier. For instance, when the power amplifier is implemented as a Field Effect Transistor, the supply voltage may be provided to a Drain terminal thereof. It will be understood, however, that the supply voltage may also be provided to a power amplifier which is implemented as a Bi-Polar transistor.

Another aspect of the invention relates to a computer program product being adapted to perform all the steps of the method described above. The computer program product may be implemented in suitable software and/or hardware.

Yet another aspect of the invention relates to a frontend, in particular to a digital frontend, for a base station, the frontend being adapted for generating an envelope signal to be provided to an ET modulator, the frontend being further adapted for advancing the envelope signal in the time domain at rising edges thereof for reducing a negative deviation between an output signal of the ET modulator and the envelope signal. Thus, the pre-processing of the envelope signal is performed in the (digital) frontend, which may typically also generate a (modulated) signal which is provided as an input signal to the power amplifier.

In this respect, it should be noted that the frontend may either generate a baseband signal which is subsequently converted to the RF domain by application of a suitable carrier signal, e.g. in a (digital or analog) mixer, or alternatively, the frontend may itself be adapted to generate an RF signal which is directly provided as an input to the power amplifier (after D/A conversion).

In either case, the frontend may be adapted for not advancing the envelope signal at failing edges thereof, thus avoiding generation of a negative deviation between the input and output signals of the ET modulator.

In another embodiment, the frontend is further adapted for shifting the envelope signal by a delay time for reducing an absolute value of a deviation between the output signal of the ET modulator and the envelope signal. In this way, efficiency improvements of the ET modulator may be obtained.

Typically, the frontend derives the envelope signal from a baseband signal or from an RF signal which is provided as an input signal to a power amplifier to which the output signal of the ET modulator is provided as a supply voltage The envelope of the signal has a comparably low frequency, typically in the range of zero to several MHz, e.g. 20 MHz, as the frequency range of the envelope signal corresponds to the (comparatively small) bandwidth of the RF signal to be amplified. The frontend typically also provides a baseband signal or an up-converted RF signal to the power amplifier, such that both signals (envelope and RF) may be provided to the power amplifier in a coordinated way.

In a further aspect, the invention relates to a transmit frontend for a base station, comprising: a frontend, in particular a digital frontend, as described above, an ET modulator to which the envelope signal is provided, and at least one power amplifier to which the output signal of the ET modulator is provided as an adaptive supply voltage. The ET modulator essentially serves as an amplifier for the envelope signal, also converting the input range of the envelope signal into a suitable voltage range.

In another embodiment, the transmit frontend further comprises a digital-to-analogue converter for performing digital-to-analogue conversion of the advanced and/or shifted envelope signal provided by the digital frontend. In a similar way, a D/A-converter may be used for conversion of the baseband signal / RF signal which is provided to the power amplifier.

Yet another aspect relates to a base station, comprising: a transmit frontend as described above, and a transmit antenna for transmission of an output signal provided by the power amplifier. Using the pre-processing of the envelope signal, the base station may perform amplification of RF signals with reduced adjacent channel power and at the same time with high efficiency.

A final aspect of the invention relates to a communications network, comprising at least one base station as described above. The reduced ACP generated by the base station will lead to smaller error rates and thus higher throughput of the network.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Figures

Exemplary embodiments are shown in the diagrammatic drawing and are explained in the description below. The following are shown:
- **Fig. 1**: shows a schematic diagram of an embodiment of a transmit frontend for a base station using the envelope tracking concept,
- **Fig. 2a**: shows a schematic diagram of output power over input power of a power amplifier,
- **Fig. 2b**: shows a schematic diagram of a class B amplifier with three different currents,
- **Fig. 3**: shows a schematic efficiency diagram in dependence of a relative output power for a Class A and a Class B amplifier, respectively,
- **Figs. 4a-c**: show schematic diagrams of a modulator response for a) a non-preconditioned envelope signal, b) a time-shifted envelope signal, and c) an envelope signal with advanced pulse rise,
- **Figs. 5a-c**: show schematic diagrams of simulated single-carrier envelope signals which are a) non-preconditioned, b) time-shifted, and c) both time-shifted and widened at raising edges thereof, and
- **Figs. 6a,b**: show schematic diagrams of a) a simulated deviation (voltage error) and b) a simulated efficiency of an envelope tracking arrangement for different values of delay and pulse widening.

### Description of the Embodiments

The functions of the various elements shown in the Figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

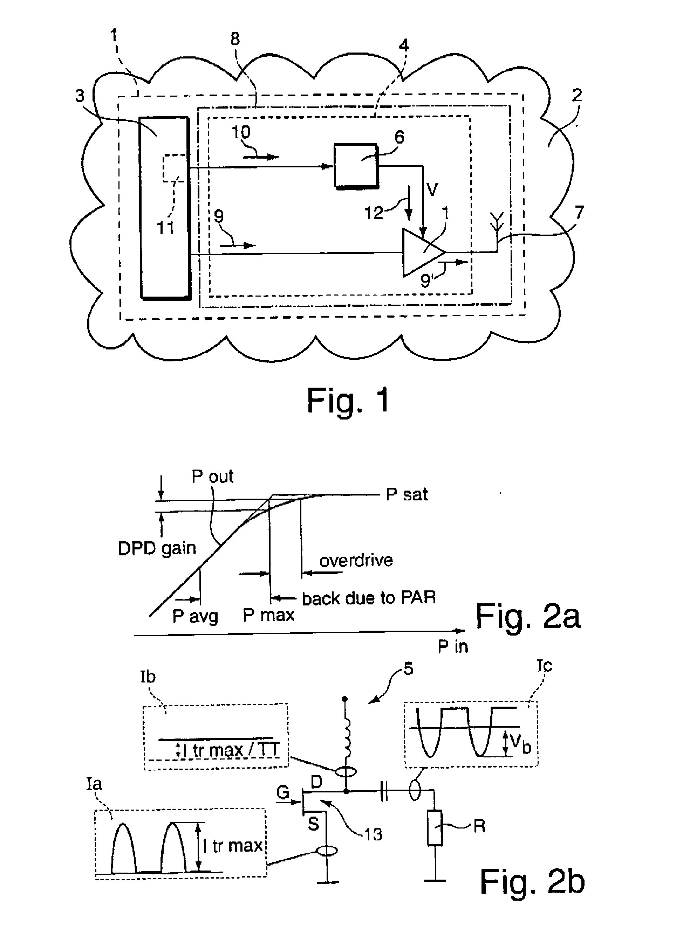

**Fig.1** shows the transmission part (transmit frontend) of a base station **1** for a wireless communications network **2**, a receive part and a baseband processing part not being shown for the sake of simplicity. The base station 1 comprises a digital frontend (unit) **3** and an Envelope Tracking, ET, amplifier arrangement **4** with a power amplifier **5** and an envelope tracking modulator **6.** An RF output signal 9' of the power amplifier 5 is provided (via an antenna network, not shown) to a transmit antenna **7** for radio transmissions. In the present example, the ET amplifier arrangement 4 and the transmit antenna 7 form part of an active antenna element **8** which is arranged remote from the digital frontend unit 3.

As can also be gathered from Fig. 1, the digital frontend 3 is adapted to provide an input signal **9** to the power amplifier 5 for amplification. In the present example, the frontend 3 is adapted to generate an RF signal which may be directly used as an input to the power amplifier 5. However, it is also possible that the frontend 3 generates a baseband signal which is up-converted to the RF domain in a mixer (not shown) before being provided to the power amplifier 5. In any case, the power amplifier 5 is typically driven as a class A or class B amplifier with a supply voltage **V** which is provided to a voltage supply terminal thereof (e.g. a Drain terminal when a field effect transistor is used). The supply voltage V is generated as an output signal **12** of the ET modulator 6 based on an envelope signal **10** which is provided from the digital frontend 3 to the ET modulator 6 after Digital-to-Analogue conversion in a D/A-converter **11** also arranged in the frontend 3. The output signal 12, resp., the supply voltage V should correspond as close as possible to an amplified version of the envelope signal 10 provided to the ET modulator 6.

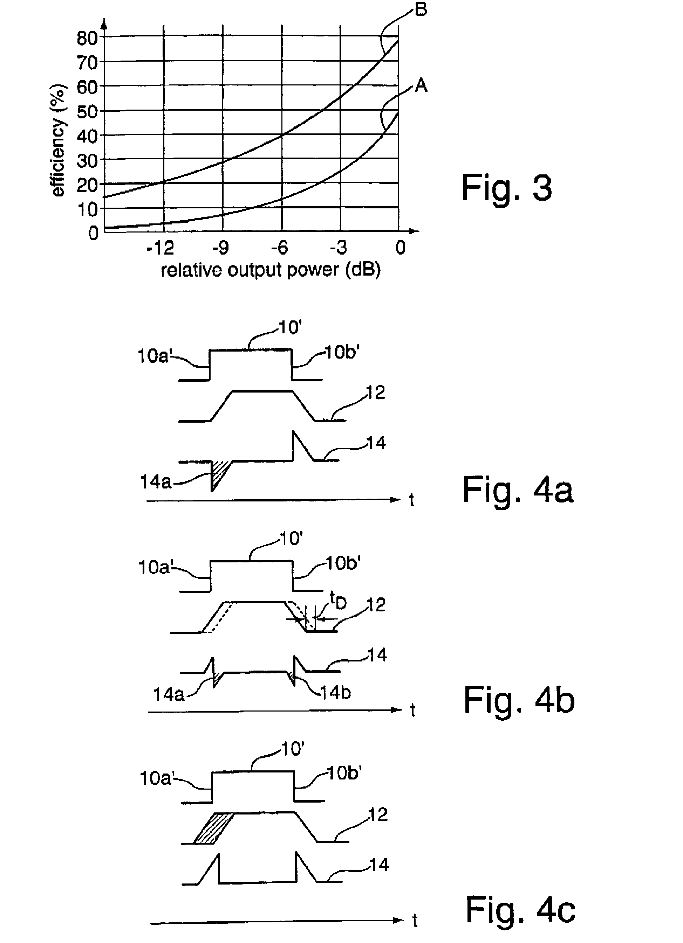

In the following, the basic principle of the ET modulation concept will be described with reference to **Figs. 2a****,b** and **Fig. 3**. Fig. 2a shows a schematic overview of the output behavior of a power amplifier in dependence of an input power **Pin**. With increasing input power Pin, the output power **Pout** also increases up to a certain level **Psat** where saturation takes place.

Fig. 2b schematically shows three current flows **la** to **lc** in a linear amplifier 5 and demonstrates that the reason for the saturation is the limitation of the generated voltage swing at a load resistor **R** by the supply voltage V at the amplifier, resp., at a drain terminal **D** of a power transistor **13,** being implemented as a field effect transistor (with Source **S** and Gate **G** terminals) . For an amplifier 5 with 100 W peak output power, a maximum value **l** tr **max** of the current at the source terminal S is in the range of 15 A. This current at the source S of the transistor 13 is split into a DC bias current **lb** at the Drain terminal thereof, which is in the order of 5 A under maximum modulation and the remaining AC current **lc** which drives the load resistor R. The load resistor R directly connected to the transistor 13 typically consists of a output matching network and a following 50 Ohm load given by the antenna. A linearization e.g. in the form of a digital pre-distortion, DPD, applied to the amplifier 5 may now make the amplifier 5 near idle. This means the power behavior in Fig. 2a goes with a hard edge to the saturation level Psat. The amplifier 5 can thus be driven with the highest possible maximum output power. This also means that the average output power of the signal defined by the PAR (peak to average ratio) of the transmitted signal, which is typically in the 6 dB range for a UMTS signal, will be maximal. Now, in the linear region of the curve of the output power Pout, the pre-distorted or ideal amplifier 5 is free to for generation of higher harmonics. The harmonics will hardly come back if the amplifier 5 is driven beyond this now hard saturation level defined by the supply voltage.

However, uneven harmonics cause adjacent channel power (ACP) for radio transmission signals generated by the transmit antenna 7 which may lead to transmission errors, such that a limiting value for ACP is specified in radio standards such as the UMTS or LTE standard which strongly limit ACP.

**Fig. 3** shows the efficiency of a Class A amplifier (curve **A**) and a Class **B** amplifier (curve B) over the relative output power (in dB). It can be gathered from Fig. 3 that maximum efficiency is provided at full power of the amplifier. However, this means that a full voltage swing at the load R or transistor 13 has to be provided. The dynamic application of the required amplifier supply voltage V for an output power level "Pout" to get an optimum efficiency is the basic principle of envelope tracking (ET): If the supply voltage V is exactly as required, the amplifier 5 operates with optimum efficiency. If the supply voltage V is higher, then there is a degradation from the best efficiency condition. However, when the supply voltage V is too low, ACP is generated and the system may fail, such that negative deviations of the supply voltage V from a desired level should be avoided in any case.

The optimum supply voltage V required for the power amplifier 5 may be determined as the magnitude of the I/Q-Signal for radio frequencies times a scaling factor which is due to the gain of the amplifier (chain) 5. The corresponding envelope signal 10 is determined in the digital frontend 3 of the transceiver and can be converted to the analog domain with the fast Digital-to-Analog converter 11.

Now, the ET modulator 6 can be seen as an amplifier with high efficiency. Although the ET modulator 6 does not have to handle an RF signal but only the low frequency envelope signal 10 having frequencies from DC to frequencies which correspond to the bandwidth of the RF signal 9 (e.g. 20 MHz) provided to the amplifier 5, to build such an ET modulator 6 is not an easy task.

In principle, the ET modulator 6 may be regarded as a filter. The output signal 12 is delayed with respect to the input signal 10 due to group delay and rise and fall times of the output signal 12 are determined by the bandwidth of the ET modulator 6.

**Fig. 4a** schematically illustrates what happens if an envelope tracking signal 10 is provided to the ET modulator 6 which is not pre-conditioned: The ET modulator 6 generates an output signal 12 which is delayed with respect to an ideal envelope tracking output signal **10'** with significant rise and fall times. The ideal output signal 10' corresponds to the envelope signal 10 which is provided to the input of the ET modulator 6 multiplied by the (voltage) amplification factor of the ET modulator 6 (e.g. a factor of 20) which is correlated to the amplification factor of the amplifier 1.

The non-ideal a transfer function of the ET modulator 6 causes a deviation **14** (difference between output signal 12 and ideal output signal 10') which is negative at a rising edge **10a'** of the idealized output signal 10' (in the hatched region **14a**), thus causing ACP. At a falling edge **10b'** of the ideal output signal 10', the deviation 14 is positive, thus causing efficiency degradation, but no ACP.

Now, whereas a slight degradation of efficiency may be acceptable, ACP can not be accepted with the need of the necessary bandwidth. Therefore, a pre-conditioning of the envelope signal 10 should be performed. As indicated in **Fig. 4b**, one way of performing a pre-conditioning of the envelope signal 10 is by shifting (advancing) the entire envelope signal 10 in the time domain by a delay time to which may e.g. correspond to the group delay of the ET modulator 6. In this case, the output signal 12 will be shifted accordingly, and an absolute value of the deviation 14 between the output signal 12 of the ET modulator 6 and the envelope signal 10 may be reduced. This is typically done in the digital domain in the frontend 3 by adjusting (advancing) the envelope signal 10 relative to the RF output signal. 9. By performing such a shift, the negative deviation **14a** at the rising edge of the envelope signal 10 can be reduced, however, a negative deviation **14b** at a falling edge of the envelope signal 10 will be produced. Thus, a simple shift of the envelope signal 10 typically cannot entirely remove a negative deviation 14a, 14b if the bandwidth of the ET modulator 6 is not sufficient.

Thus, it is suggested to use a pre-conditioning of the envelope signal 10 as represented in **Fig. 4c**. If a look ahead of the envelope signal 10 is done, the rise of the output signal 12 will correspondingly start earlier and reaches the required level in time. No negative deviations occur which may lead to ACP, albeit at the cost of a larger positive deviation with a (tolerable) loss of efficiency. Thus, in principles, a look ahead may convert ACP error to efficiency error. It will be understood that a widening of the envelope signal 10 may only be applied at rising edges thereof, but not at falling edges, for avoiding to cause negative deviations 14b as shown in Fig. 4b.

The look ahead time which is required for the present purposes is dependent on the response time and bandwidth of the ET modulator 6: If the ET modulator 6 is fast enough, no look ahead is necessary, as rise and fall times are sufficiently small. The other extreme is an ultra-low ET modulators (with a fixed supply voltage). In this case, the supply voltage V should be set to the maximum necessary voltage. This represents the situation with no ET and no gain in efficiency. All dynamic cases in between this extremes are possible and may be addressed with the look ahead method in order to increase the efficiency from the no ET case to the pure ET case, depending on the bandwidth of the ET modulator 6.

Like the shift, the look-ahead / advancing of the envelope signal 10 may be performed in the digital frontend 3 before conversion to the analog domain in the Digital-to-Analog converter 11. It will be understood that the advancing of the envelope signal 10 may be combined with the shifting represented in Fig. 4b, as will be described in greater detail below.

It should also be noted that the look-ahead method is different from working with the inverse transfer function of the ET modulator 6, as it has no impact on the falling edge 10b of the envelope signal 10- It therefore does not need a higher input signal to compensate gain degradations at high frequencies.

The implementation of the advancing of the envelope signal 10 may be very simple. The widening of the envelope signal 10 may be performed e.g. by the following short algorithm given in pseudo-code (for instance for a sampling rate of 92.16 MHz):

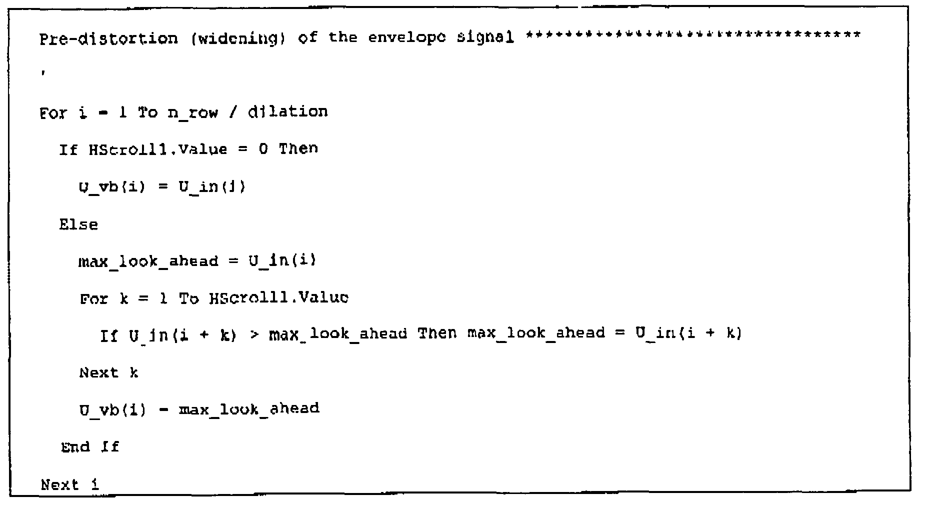

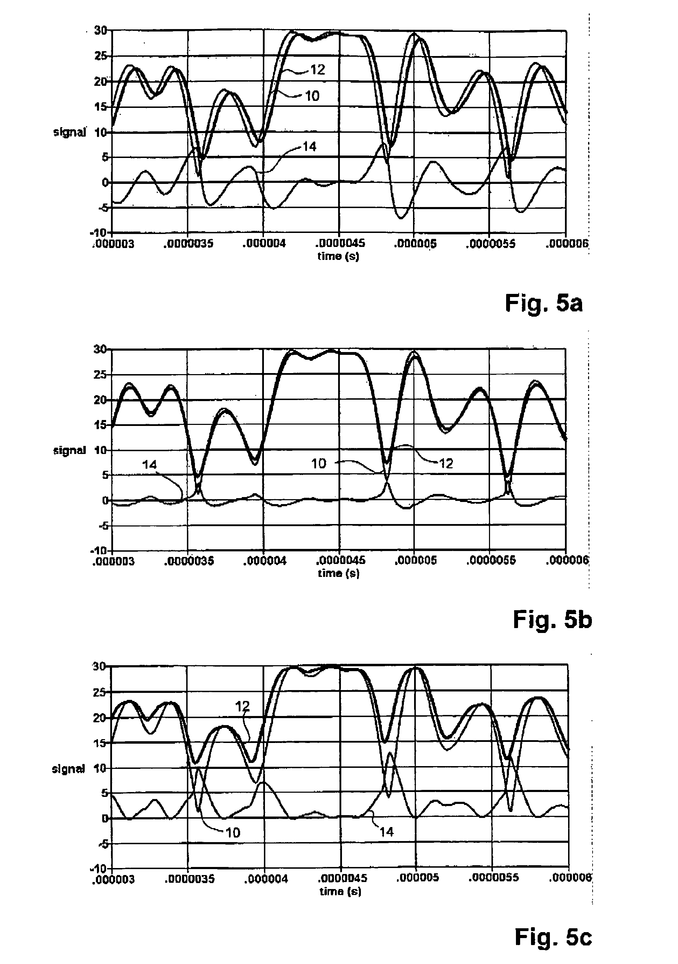

**Fig. 5a** shows exemplary simulation results based on a single-carrier WCDMA signal, when no envelope signal delay compensation and no "signal widening" is applied. A deviation curve 14 corresponds to the voltage error between the modulator output signal 12 and the modulator input signal 10 (re-scaled by the voltage amplification factor of the ET modulator 6). As indicated above, since a negative voltage error leads to an overall ET system linearity degradation, negative voltage errors have to be avoided. For the constellation in Fig. 5a, clear negative voltage errors 14 and thus high non-linearity and ACP will appear.

**Fig. 5b** shows simulation results of the same signal, but with a suitable delay adaptation. It can be gathered from Fig. 5b that the negative voltage error of the deviation curve 14 has been reduced, but still clear negative voltage errors 14 do appear, leading to an overall system linearity degradation, still causing Adjacent Channel Power, ACP.

**Fig. 5c** shows the simulation results when both the delay has been aligned and a suitable envelope signal widening (at rising edges) has been performed, achieved by the proposed look-ahead algorithm. As can be gathered from Fig. 5c, the voltage error curve 14 doesn't show a negative voltage error any more. Thus, the overall ET system linearity is not affected by the limited bandwidth of the ET modulator any more.

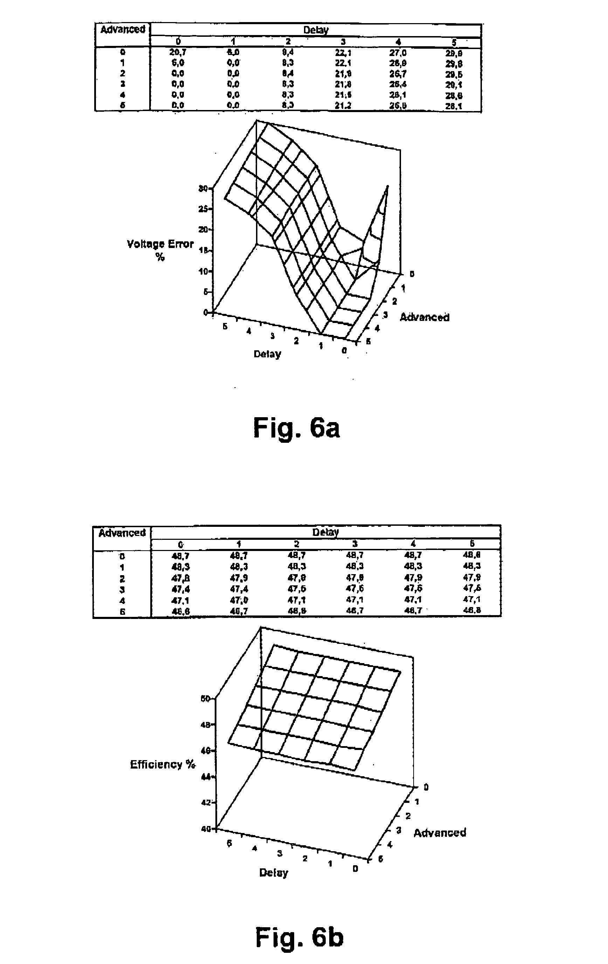

**Fig, 6a** shows simulation results of the voltage error for different delay times and for different look-ahead time-steps (indicated as "advanced"), which correspond to the degree of the pulse widening performed at rising edges 10a of the envelope signal 10. As is apparent from Fig. 6a, already for one or two time-steps of advancing the signal, a very low (almost) zero voltage error may be achieved. In this respect, it should be noted that the voltage error in the simulation designates the percentage of time in a transmission frame where the negative deviation 14 of the modulator output voltage signal 12 is larger than 0.5 V.

**Fig. 6b** finally shows the resulting overall efficiency degradation caused by the look-ahead algorithm (and signal widening). Simulated efficiency values are shown over different delays and for a different number of time-steps (indicated as "advanced"), which correspond to the degree of the pulse widening. In the present example, for the required one ore two time-steps (which correspond to a very low or almost zero voltage error), the efficiency degradation is very low (in the example in the range of 1 or 2 percent). In this efficiency simulation, an (almost) real ET modulator including switching losses and linear amplifier losses has been used, such that the simulation results shown herein are clearly indicative also for a physical implementation of an ET modulator.

In summary, the method and system proposed above allows to clearly improve overall Envelope Tracking linearity with only low efficiency degradation. By applying the method, the linearity degradation due to limited modulator bandwidth can be clearly reduced and thus overall system linearity of an ET amplifier arrangement can be improved. The proposed method / system thus allow to use bandwidth limited commercially available components (within a certain range) as ET modulators also for multi-carrier signals covering a large signal bandwidth, e.g. for WCDMA signals.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also, the description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Method for conditioning of an envelope signal (10) to be provided as an input signal to an envelope tracking, ET, modulator (6), comprising:
advancing the envelope signal (10) in the time domain at rising edges thereof for reducing a negative deviation (14a) between an output signal (12) of the ET modulator (6) and the envelope signal (10).

2. Method according to claim 1, wherein the envelope signal (10) is not advanced at falling edges thereof,

3. Method according to claim 1 or 2, further comprising: shifting the envelope signal (10) in the time domain by a delay time (t_{D}) for reducing an absolute value of a deviation (14) between the output signal (12) of the ET modulators (6) and the envelope signal (10).

4. Method according to any one of the preceding claims, wherein the advancing and/or the shifting of the envelope signal (10) is performed in the digital domain.

5. Method according to claim 4, further comprising: performing a digital-to-analog conversion of the advanced and/or shifted envelope signal (10) before providing the envelope signal (10) to the ET modulator (6).

6. Method according to any one of the preceding claims, wherein the output signal (12) of the ET modulator (6) is provided as a supply voltage (V) to a power amplifier (5).

7. Computer program product being adapted to perform all the steps of the method according to any one of the preceding claims.

8. Frontend, in particular digital frontend (3), for a base station (1), the frontend (3) being adapted for generating an envelope signal (10) to be provided to an ET modulator (6), the frontend (10) being further adapted for advancing the envelope signal (10) in the time domain at rising edges thereof for reducing a negative deviation (14) between an output signal (12) of the ET modulator (6) and the envelope signal (10).

9. Frontend according to claim 8, being further adapted for not advancing the envelope signal (10) at falling edges (10b) thereof.

10. Frontend according to claim 8 or 9, further comprising: shifting the envelope signal (10) by a delay time (t_{D}) for reducing an absolute value of a deviation (14) between the output signal (12) of the ET modulator (6) and the envelope signal (10).

11. Frontend according to any one of claims 8 to 10, being adapted to derive the envelope signal (10) from a baseband signal or an RF signal (9).

12. Transmit frontend (3, 4) for a base station (1), comprising:
a frontend, in particular a digital frontend (3), according to any one of claims 8 to 11,
an ET modulator (6) to which the envelope signal (10) is provided, and
at least one power amplifier (5) to which the output signal (12) of the ET modulator (6) is provided as an adaptive supply voltage (V)

13. Transmit frontend according to claim 12, further comprising a digital-to-analogue converter (11) for performing digital-to-analogue conversion of the advanced and/or shifted envelope signal (10) provided by the digital frontend (3).

14. Base station (1), comprising:
a transmit frontend (3, 4) according to claim 12 or 13, and
a transmit antenna (7) for transmission of an output signal provided by the power amplifier (5).

15. Communications network (2), comprising at least one base station (1) according to claim 14.
